## Europäisches Patentamt

## European Patent Office

## Office européen des brevets

(11) Publication number: **0 190 799**
**B1**

## EUROPEAN PATENT SPECIFICATION

(45) Date of publication of the patent specification:
06.06.90

(51) Int. Cl.⁵: **G03F 7/095**, G03F 7/033

(21) Application number: **86200142.7**

(22) Date of filing: **03.02.86**

(54) Method of manufacturing a device:.

(30) Priority: **06.02.85 NL 8500320**

(43) Date of publication of application:
**13.08.86 Bulletin 86/33**

(45) Publication of the grant of the patent:
**06.06.90 Bulletin 90/23**

(84) Designated Contracting States:
**DE FR GB NL**

(56) References cited:
**EP-A- 0 111 274**

**PATENTS ABSTRACTS OF JAPAN, vol. 1, no. 21, 25th March 1977, page 923 E 76; & JP - A - 51 120 712**

(73) Proprietor: **N.V. Philips' Gloeilampenfabrieken, Groenewoudseweg 1, NL-5621 BA Eindhoven(NL)**

(72) Inventor: **Wijdenes, Jacob, c/o INT. OCTROOIBUREAU B.V. Prof. Holstlaan 6, NL-5656 AA Eindhoven(NL)**
Inventor: **Geomini, Marcellinus Joseph Hendrikus Jacobus, c/o INT. OCTROOIBUREAU B.V. Prof. Holstlaan 6, NL-5656 AA Eindhoven(NL)**

(74) Representative: **Weening, Cornelis et al, INTERNATIONAAL OCTROOIBUREAU B.V. Prof. Holstlaan 6, NL-5656 AA Eindhoven(NL)**

## Description

The invention relates to a method of manufacturing a device, in which method an intermediate layer is formed from a first photosensitive lacquer on a substrate surface and is covered with a top layer formed from a second photosensitive lacquer, the top layer is patternwise exposed to radiation and is then developed so as to form an apertured mask, the intermediate layer then being exposed to radiation using the developed top layer as a mask, the second photosensitive lacquer comprising a binder, a positive acting photosensitizer and a solvent in which the intermediate layer is only slightly soluble.

The method according to the invention is used, for example, in the manufacture of a semiconductor device.

The method mentioned in the opening paragraph is described in the publication "Materials for multilevel resist schemes" by E. Reichmanis, C.W. Wilkins, Jr. and E. Ong, in Polymer Engineering and Science, 23, December 1983, pp. 1039-1042, in which the intermediate layer is a polymethyl methacrylate and the top layer is a positive acting photosensitive lacquer based on a novolak resin. Novolak is a condensation product of phenol and formaldehyde.

The said publication describes how a transition layer is formed at the interface between the first and the second lacquer layers and this causes difficulties when exposing and developing the intermediate layer, inter alia by light absorption and diffraction. Therefore, additional steps are necessary in the method to remove the transition layer of to make it harmless. On the other hand it is possible to choose a solvent for the top layer in which polymethyl methacrylate has a very poor solubility. As a result of this the formation of the transition layer is only partly inhibited.

It is the object of the invention to provide a method of manufacturing a device by using a bilayer photosensitive lacquer system in which the formation of the transition layer takes place to a considerably reduced extent.

For that purpose, the method described in the opening paragraph is characterized in that the binder is selected from the group of polymers which is formed by polyhydroxystyrenes and halogenated polyhydroxystyrenes.

Upon developing, the top layer shows an especially large solubility difference between the exposed and unexposed parts in an embodiment of the method according to the invention which is characterized in that the binder is poly-para-hydroxystyrene.

The formation of the transition layer is counteracted to a particularly strong extent if the binder is a brominated poly-para-hydroxystyrene compound having on an average 1 to 2 substituted bromine atoms per phenyl group.

A preferred embodiment of the method according to the invention is characterized in that the binder is poly(2,4-dihydroxystyrene).

Although the use of polyhydroxystyrene (also termed) "polyvinylphenol") in a multilayer system has been described in the publication "Multilayer resists for fine line optical lithograph" by E. Ong and E.H. Hu in Solid State Technology, June 1984, pp. 155-160, the polyhydroxystyrene in said publication forms a constituent of a negative acting photosensitive lacquer. There, the disadvantage occurs that the transition layer is exposed and thereby strengthened in the pattern-wise exposure of the top layer. As a result of this, the transition layer is difficult to remove entirely at a later stage.

Suitable positive acting photosensitizers are multiple esters of trihydroxybenzophenone and 2-diazo-1-naphthoquinone-4-sulphonyl chloride of 2-diazo-1-naphthoquinone-5-sulphonyl chloride. The tri-esters or a mixture of bi-esters and tri-esters are preferably used.

Photosensitive lacquers based on polyhydroxystyrene and esters of o-quinone diazide sulphonic acid are described in German Patent Application DE 3309222, but the use in a bilayer system is not described therein. The lacquers according to the said German Patent Application are not suitable for use in the method according to the invention because the solvents used, for example 2-ethoxy-ethyl acetate, enhance the formation of a transition layer.

The transmission of light having a wavelength of 200 nm through the transition layer exceeds 80%, which indicates a very thin transition layer, if in the method according to the invention the solvent of the second photosensitive lacquer is selected from the group formed by cyclohexanone and 2-ethoxy-ethanol.

The top layer can be developed in the conventional manner, for example, by using a metal ion-free basic solution, for example trismethyl ammonium hydroxide in water.

In a preferred embodiment of the method according to the invention the intermediate layer comprises a polymer or a copolymer of methyl methacrylate. Very suitable is polymethyl methacrylate, but copolymers with, for example, other alkyl methacrylates, methyl acrylate and methacrylonitrile can also be used successfully.

The intermediate layer can be developed in a conventional manner. The intermediate layer may, for example be developed by using a solvent, for example methyl isobutyl ketone by which the remainders of the top layer are also dissolved.

In connection with the further treatments to which the device is subjected (for example chemical etching, ion etching or deposition of a metal layer, succeeded by removal of the remainders of the intermediate layer), it may be of importance for the remainders of the top layer to remain on the developed intermediate layer as an extra protection. In such a case it is efficacious for the intermediate layer to be developed with a solvent selected from the group formed by chlorobenzene, xylene and toluene.

Embodiments of the method according to the invention and comparative examples will be described in greater detail with reference to the drawing, in which:

Figures 1a - e show diagrammatically a possible application of the method according to the invention,
Figures 2a - c show diagrammatically an alternative application of the method according to the invention, and
Figures 3a - b show an embodiment of the photosensitive component of the top layer.

Example 1 of the method according to the invention.

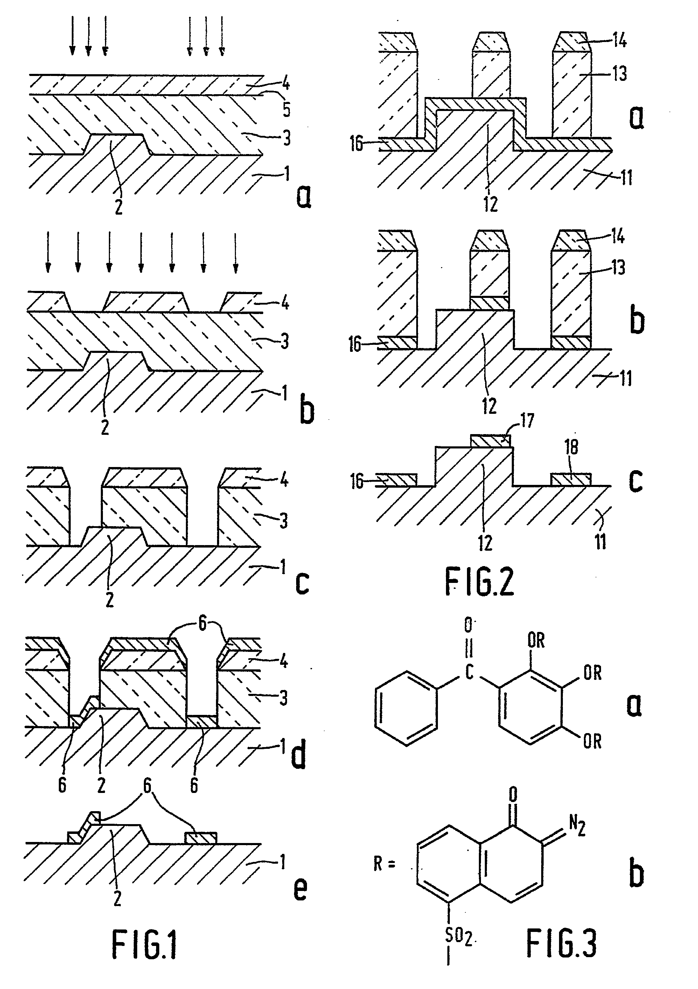

Figure 1a is a diagrammatic sectional view of a silicon substrate 1 on the surface of which steps and bosses 2 may be present. An intermediate layer 3 of polymethyl methacrylate having a thickness of 1 to 4 μm is provided in a conventional manner on the substrate 1, for example, by spinning a solution in chlorobenzene. This solvent is then removed by heating to 150°C for 30 minutes. The intermediate layer 3 has a substantially flat surface.

A top layer 4 using a second photosensitive lacquer, is then provided, for example, also by spinning. Said photosensitive lacquer consists of 17% by weight of poly-para-hydroxystyrene as a binder (molecular weight 1500 - 7000 of Messrs. Polyscience Inc.), 78% by weight of cyclohexanone as a solvent and 5% by weight of the tri-ester of 2,3,4-trihydroxybenzophenone and 2-diazo-1-naphthoquinone-5-sulphonyl-chloride as a photosensitive component (Figure 3a, wherein R is shown in Figure 3b). Before providing the lacquer it is filtered through a filter having pore diameters of at most 0.2 μm. The top layer is dried at 80°C for 30 minutes and after drying has a thickness from 0.3 to 1.5 μm.

A transition layer 5 is formed at the interface between the intermediate layer 3 and the top layer 4. This layer is very thin and does not cause the problems occurring when other binders and solvents are used in the second photosensitive lacquer. The transmission of light through the transition layer is 90% at a wavelength of 200 nm and 95% at 220 nm. For comparison: a transition layer having a thickness of not more than 30 nm which is formed when a known photosensitive lacquer HPR 204 of Messrs. Hunt (on the basis of novolak) is used causes a transmission of only 30% at 220 nm. The transmission is measured by an absorption determination on a quartz substrate with polymethylmethacrylate as the reference.

The substrate 1 with the photosensitive lacquer layers 3 and 4 is exposed in the form of a pattern through a mask (not shown) by means of light in a wavelength range from 350 - 450 nm (see Figure 1a). The polymethylmethacrylate in layer 3 is not sensitive to said light, but is sensitive to light having a wavelength shorter than 250 nm.

The exposed parts of the top layer 4 are dissolved (see Figure 1b) with developer N437 of Messrs. Shipley, diluted 1 : 1 with water, for 1 minute. Said developer is a metal ion-free basic solution.

The substrate 1 with the photosensitive layers 3 and 4 is then exposed throughout the surface to parallel UV radiation having a wavelength of 190 - 250 nm (see Figure 1b), the mask formed in the top layer 4 ensuring a patterned radiation of the intermediate layer 3.

The exposed part of the intermediate layer 3 is then dissolved in toluene, apertures being formed in the intermediate layer having side-walls extending substantially perpendicularly to the substrate 1, the remainders of the top layer 4 not being dissolved (Figure 1c). Other solvents, for example chlorobenzene or xylene, may be used instead of toluene. If on the contrary a more polar solvent, for example, methyl isobutyl ketone, is used, the remainders of the top layer 4 also dissolve. However, if the pattern formed in the intermediate layer 3 is used to serve as a mask in an ion etching treatment of the substrate 1, it is efficacious to use the remainders of the layer 4 as a protection of the non-exposed parts of the intermediate layer 3.

The pattern formed in the intermediate layer 3 may be used in various conventional manners in the further manufacture of the device. The pattern may serve as a mask in a chemical or plasma etching treatment or ion implantation.

It is also possible (Figure 1d) to provide a metal layer 6, for example, by vapour deposition of aluminium. When the remainders of the layers 3 and 4 are then dissolved, a part of said metal layer 6 may be removed (so-called "lift-off" process) with the result that the substrate 1 has a pattern of metal tracks (Figure 1e).

Example 2 of the method according to the invention.

Figure 2a shows a silicon substrate 11 on the surface of which steps and bosses 12 may be present. The substrate 11 is covered with a conductor layer 16, for example of polysilicon, and with the intermediate and top layers 13 and 14 in which a pattern is provided in the manner described in example 1.

This pattern is used as a mask during etching of the conductive layer 16. Etching may be carried out in any known manner, for example, by chemical etching or by etching with reactive ions. A pattern (Figure

2b) is formed in the conductive layer 16 after which the remainders of the intermediate and top layers 13 and 14 may be removed, for example by a treatment with an oxygen plasma.

The width of the conductor tracks, for example 17 and 18, is determined by the mask used in the first exposure and by the nature of the further processes, but hardly by the presence of steps or bosses 12 on the substrate 11, as a result of which track width variations at the crossings of such steps occur only to a small extent.

Alternative example of the method according to the invention.

In the method according to the invention other solvents may also be used in the second photosensitive lacquer, provided the solvent does not attack the intermediate layer 3. Particularly suitable is, for example, 2-ethoxy-ethanol the use of which even results in the measured transmission through the transition layer 5 being larger than when cyclohexanone is used, which indicates a still thinner transition layer 5.

The overall concentration of binder and photosensitizer in the lacquer may be adapted at will. In order to obtain a good spinnability this overall concentration is, for example, 10 to 40% by weight, preferably approximately 25% by weight.

The ratio of binder to photosensitizer in the composition of the second photosensitive lacquer can freely be chosen within certain limits. If the ratio of binder to photosensitizer is greater than 8 : 1, however, the rate of dissolution of the unexposed part of the top layer becomes too large, for example more than 1 μm/min, as a result of which the top layer 4 shows little selectivity. On the other hand it is not advisable to choose a ratio smaller than 2 : 1 because there is no further improvement of the result. Due to the comparatively high cost of the photosensitizer a ratio of approximately 3 : 1 is to be preferred.

Poly-para-hydroxystyrene is used as a binder in the above-described example. Poly-ortho-hydroxystyrene and poly(2,4-dihydroxystyrene) may also be used in the lacquer layer 4 in the method according to the invention. When brominated poly-para-hydroxystyrene compounds with on an average 1.5 bromine atoms per phenyl ring are used, the transmission of light of a wavelength of 220 nm through the transition layer 5 is even more than 98%. When the brominated compounds are used it is necessary to further dilute the developer, for example, in a ratio of 1 : 4 to 1 : 8, with water, the rate of developing decreasing.

Because the problems with the transition layer are considerably reduced in the method according to the invention, there is more freedom in the choice of the molecular weight and the glass transition temperature of the binder and in the drying temperature than, for example, when novolak is used. Poly-para-hydroxystyrene having a molecular weight between 1,500 and 30,000 has proved to be useful, the molecular weight preferably being smaller than 7,000 (All molecular weights stated are number-averaged molecular weights of the polymer molecules). The glass transition temperature of polyhydroxystyrene is approximately 200°C, that of novolak, dependent on the type, 100 - 130°C. The result of this is that the mobility of the polyhydroxystyrene molecules remains low and little interdiffusion takes place between the top layer and the intermediate layer, as a result of which the formation of a transition layer is suppressed.

Comparative examples.

The transmission values recorded in the Table are measured at a wavelength of 200 nm through the transition layer which is formed on polymethyl methacrylate when various combinations of binders and solvents in the second photosensitive lacquer are used to form the top layer. The novolak PN 430 of Messrs. Hoechst comprises a diazoquinone as a photosensitive component, the poly-hydroxystyrenes of Messrs. Polyscience Inc. comprise the above-described tri-ester (Figures 3a, b). MW denotes the average molecular weight. It will be obvious from the Table that the compositions according to the invention show a particularly great transmission and hence a thin transition layer. It furthermore appears that 2-ethoxy-ethanol and cyclohexanone are very suitable solvents for use in the method according to the invention.

## TABLE

|  | novolak PN 430 | poly-p-hydroxy-styrene MW 2000–7000 | poly-p-hydroxy-styrene MW 30000 |
|---|---|---|---|
| 2-ethoxy-ethanol | 27 | 91*) | 85*) |
| cyclohexanone | 16 | 87*) | 80*) |
| 2-ethoxy-ethyl acetate | 25 | 52 | 32 |
| diethyleneglycol dimethyl ether | 23 | 60 | — |

*) only these examples are according to the invention.

It has proved possible by means of the method according to the invention to make well-defined patterns with tracks having a width which is smaller than 1 μm, in which the width does not vary substantially if such a track crosses a step on the surface of the substrate.

It will be obvious that the above-described method permits many modifications without departing from the scope of this invention. The method may also be applied to other substrate materials and to multilayer substrates. Other acrylate or methacrylate-containing polymers which are sensitive to radiation of short-wave UV-light may also be used for the intermediate layer.

## Claims

1. A method of manufacturing a device, in which method an intermediate layer is formed from a first photosensitive lacquer on a substrate surface and is covered with a top layer formed from a second photosensitive lacquer, the top layer is patternwise exposed to radiation and is then developed so as to form an apertured mask, the intermediate layer then being exposed to radiation using the developed top layer as a mask, the second photosensitive lacquer comprising a binder, a positive acting photosensitizer and a solvent in which the intermediate layer is only slightly soluble, characterized in that the binder is selected from the group of polymers which is formed by polyhydroxystyrenes and halogenated polyhydroxystyrenes.

2. A method as claimed in Claim 1, characterized in that the binder is poly-para-hydroxystyrene.

3. A method as claimed in Claim 1, characterized in that the binder is a brominated poly-para-hydroxystyrene compound having on an average 1 to 2 substituted bromine atoms per phenyl group.

4. A method as claimed in Claim 1, characterized in that the binder is poly(2,4-dihydroxystyrene).

5. A method as claimed in any of the Claims 1 to 4, characterized in that the photosensitizer is a multiple ester of trihydroxybenzophenone and 2-diazo-1-naphthoquinone-4-sulphonyl chloride or 2-diazo-1-naphthoquinone-5-sulphonyl chloride.

6. A method as claimed in any of the Claims 1 to 5, characterized in that the solvent of the second photosensitive lacquer is selected from the group formed by cyclohexanone and 2-ethoxy-ethanol.

7. A method as claimed in any of the Claims 1 to 6, characterized in that the intermediate layer comprises a polymer or copolymer of methyl methacrylate.

8. A method as claimed in Claim 7, characterized in that the intermediate layer is developed by means of a solvent selected from the group formed by chlorobenzene, xylene and toluene.

## Patentansprüche

1. Verfahren zum Herstellen einer Einrichtung, wobei auf der Substratoberfläche eine Zwischenschicht eines ersten lichtempfindlichen Lackes angebracht wird, die mit einer Deckschicht eines zweiten lichtempfindlichen Lackes bedeckt wird, die musterartig bestrahlt und danach entwickelt wird zum Bilden einer mit Löchern versehenen Maske, wonach die Zwischenschicht unter Verwendung der entwickelten Deckschicht als Maske, bestrahlt wird, wobei der zweite lichtempfindliche Lack ein Bindemittel, eine positiv wirkende lichtempfindliche Komponente und ein Lösungsmittel aufweist, in dem die Zwischenschicht sich nur schwer lösen läßt, dadurch gekennzeichnet, daß das Bindemittel aus der Gruppe von Polymeren gewählt worden ist, die durch Polyhydroxystyrole und halogenierte Polyhydroxystyrole gebildet wird.

2. Verfahren nach Anspruch 1, dadurch gekennzeichnet, daß das Bindemittel Poly-Para-Hydroxystyrol ist.

3. Verfahren nach Anspruch 1, dadurch gekennzeichnet, daß das Bindemittel eine bromierte Poly-Para-Hydroxystyrolverbindung ist mit im Schnitt 1 bis 2 substituierten Bromatomen je Phenylgruppe.

4. Verfahren nach Anspruch 1, dadurch gekennzeichnet, daß das Bindemittel Poly(2,4-Dihydroxystyrol) ist.

5. Verfahren nach einem der Ansprüche 1 bis 4, dadurch gekennzeichnet, daß die lichtempfindliche Komponente ein mehrfacher Ester von Trihydroxybenzophenon und 2-Diazo-1-Naphthochinon-4-Sulfonylchlorid oder 2-Diazo-1-Naphthochinon-5-Sulfonylchlorid ist.

6. Verfahren nach einem der Ansprüche 1 bis 5, dadurch gekennzeichnet, daß das Lösungsmittel des zweiten lichtempfindlichen Lackes aus der Gruppe gewählt ist, die durch Cyclohexanon und 2-Äthoxyäthanol gebildet wird.

7. Verfahren nach einem der Ansprüche 1 bis 6, dadurch gekennzeichnet, daß die Zwischenschicht ein Polymer oder ein Copolymer von Methylmethacrylat ist.

8. Verfahren nach Anspruch 7, dadurch gekennzeichnet, daß die Zwischenschicht mit einem Lösungsmittel entwickelt wird, das aus der Gruppe gewählt ist, die durch Chlorbenzol, Xylol und Toluol gebildet wird.

## Revendications

1. Procédé pour la fabrication d'un dispositif selon lequel une couche intermédiaire en un premier vernis photosensible est formée sur une surface de substrat et est recouverte d'une couche supérieure en un deuxième vernis photosensible, la couche supérieure est exposée suivant une configuration à du rayonnement et ensuite développée de façon à former un masque perforé, après quoi la couche intér- mediaire est exposée à du rayonnement, la couche supérieure développée faisant office de masque, le deuxième vernis photosensible contenant un liant, un photosensibilisateur à effet positif et un solvant dans lequel la couche intermédiaire n'est que légèrement soluble, caractérisé en ce que le liant est choisi dans le groupe de polymères formé par des polyhydroxystyrènes et des polyhydroxystyrènes halogénés.

2. Procédé selon la revendication 1, caractérisé en ce que le liant est polyparahydroxystyrène.

3. Procédé selon la revendication 1, caractérisé en ce que le liant est un composé de polyparahydroxystyrène bromuré comptant en moyenne, comme substituants, 1 à 2 atome(s) de brome par groupe de phényle.

4. Procédé selon la revendication 1, caractérisé en ce que le liant est du poly(2,4-dihydroxystyrène).

5. Procédé selon l'une des revendications 1 à 4, caractérisé en ce que le photosensibilisateur est un multiple de trihydroxybenzophénone et de chlorure 2-diazo-1-naphtoquinone-4-sulfonylique ou de chlorure 2-diazo-1-naphtoquinone-5-sulfonylique.

6. Procédé selon l'une des revendications 1 à 5, caractérisé en ce que le solvant de la deuxième couche photosensible est choisi dans le groupe formé par le cyclohexanone et le 2-éthoxy-éthanol.

7. Procédé selon l'une des revendications 1 à 6, caractérisé en ce que la couche intermédiaire contient un polymère ou un copolymère de méthacrylate de méthyle.

8. Procédé selon la revendication 7, caractérisé en ce que la couche intermédiaire est développée à l'aide d'un solvant choisi dans le groupe formé par le chlorobenzène, le xylène et le toluène.

FIG.1

FIG.2

FIG.3